## Europäisches Patentamt
## European Patent Office
## Office européen des brevets

(11) Publication number:

# 0 030 813
# B1

# EUROPEAN PATENT SPECIFICATION

(45) Date of publication of patent specification: **31.07.85**

(51) Int. Cl.⁴: **H 03 K 5/02**

(21) Application number: **80304344.7**

(22) Date of filing: **03.12.80**

(54) Boosting circuits.

(30) Priority: **05.12.79 JP 157751/79**

(43) Date of publication of application:
**24.06.81 Bulletin 81/25**

(45) Publication of the grant of the patent:
**31.07.85 Bulletin 85/31**

(84) Designated Contracting States:
**DE FR GB NL**

(56) References cited:
**US-A-3 646 369**

(73) Proprietor: **FUJITSU LIMITED**
**1015, Kamikodanaka Nakahara-ku**
**Kawasaki-shi Kanagawa 211 (JP)**

(72) Inventor: **Nakano, Masao**
**473-4, Hisasue Takatsu-ku**
**Kawasaki-shi Kanagawa. 211 (JP)**
Inventor: **Baba, Fumio**
**3-12-204, Sakonyama Asahi-ku**
**Yokohama-shi Kanagawa, 241 (JP)**
Inventor: **Mochizuki, Hirohiko**
**43-10-908, Toyama-cho shinjyuku-ku**
**Tokyo, 162 (JP)**

(74) Representative: **Bedggood, Guy Stuart et al**
**Haseltine Lake & Co. Hazlitt House 28**
**Southampton Buildings Chancery Lane**
**London WC2A 1AT (GB)**

Courier Press, Leamington Spa, England.

## Description

The present invention relates to boosting circuits, and more particularly to boosting circuits which boost or shift up the level of a clock signal and derive a boosted clock signal having a voltage higher than a power source voltage.

In the past the power source voltage selected for use with integrated circuits (IC) was 12 volts, for example. However, there has been a tendency recently to reduce the power source voltage to 7 volts or 5 volts for example. This tendency has been encouraged by improvements in the performances of transistors, the need for matching with levels of transistor-transistor logic (TTL) circuits, etc. In order to speed up operational speeds of, for example, IC memories operated at such reduced voltage, the employment of a circuit for boosting or shifting up the level of a clock signal is required.

A conventional boosting circuit, applied to a word line driver for a memory for example, comprises a boosting capacitor one end of which is connected to a line connected to the word line and to the other end of which is applied a clock signal. A load capacitor such as stray capacitance of the word line driving circuit is charged up to power source voltage ($V_{DD}$) by an output clock signal of a driver. When the boosting capacitor, which has already been charged by the driver, is applied in accordance with the clock signal, the charge of the boosting capacitor is transferred to the load capacitor thereby to shift up the voltage of the load capacitor.

As will be described hereinafter with reference to the accompanying drawings, the value of the boosted voltage of the load capacitor is determined by the ratio of the capacitances of the boosting and load capacitors. In order to obtain a desired boosted voltage, the larger the capacitance of the load capacitor is, the larger the capacitance of the boosting capacitor should be.

In such a conventional circuit, the boosting capacitor and the load capacitor are both considered to be loads for the driver, since the driver charges the boosting capacitor. Accordingly, in a case in which the capacitances of the boosting and load capacitors are equal to each other, for example, the driver has to drive the total load which is twice as much as the load capacitor alone. This results in deformation and rounding of a voltage waveform, whereby the operational speed of the memory becomes slow in a case in which the load on the driver is the word line driving circuit.

US—A—3 646 369 discloses a multiphase field effect transistor DC driver offering a voltage boosting circuit which provides a boosted voltage level on the gate electrode of a field effect transistor driver in response to a logic input signal during a second phase of a four phase clock cycle.

In a first phase the gate electrode is driven to a first voltage by driver circuitry. A first capacitance, having one end connected to receive a control signal dependent upon a second phase clock signal, is separately charged up from its other end.

A field effect transistor connected as a rectifying device has one end connected to the gate electrode and its other end connected to the said other end of the first capacitance.

When, in the second phase, the said one end of the first capacitance receives the control signal, the first capacitance is connected through the rectifying device to the gate electrode to boost it above the first voltage.

The rectifying device is closed whilst the first capacitance is being charged in the first phase.

A second capacitance has one end connected to receive the control signal and its other end connected to a further transistor which is in turn connected to the driver circuitry.

The voltage boosting circuit of US—A—3 646 369 suffers the disadvantage of requiring multiphase clock signals. Further when a boosted voltage level on the gate electrode is brought down in response to a different logic input signal, a DC path is formed in the circuit, with undesirable effects, through the rectifying device. Moreover the rectifying device reduces the maximum boosted voltage level which can be achieved for the gate electrode.

According to the present invention there is provided a boosting circuit, for boosting the voltage of a load capacitance when charged to a specific voltage, which boosting circuit comprises a boosting capacitance, one end of which is connected to receive a boost capacitance discharge signal, characterised in that a charging circuit for charging the boosting capacitance is provided separately from driver circuitry operable to charge the load capacitance to the said specific voltage and operable to discharge the load capacitance, a gate circuit, comprising a first transistor, is provided between the load capacitance and the other end of the boosting capacitance, and a gate control circuit is provided for opening the gate circuit for discharging the boosting capacitance, when the said one end thereof is supplied with the boost capacitance discharge signal, into the load capacitance, and for closing the gate circuit when the load capacitance is being charged by the said driver circuitry operable to charge the load capacitance to the said specific voltage and when the load capacitance is being discharged by the driver circuitry, the gate control circuit comprising an auxiliary capacitance one end of which is arranged to receive the boost capacitance discharge signal and the other end of which is connected to the gate circuit, and a second transistor connected between the other end of the auxiliary capacitance and driver circuitry operable to charge the load capacitance to the said specific voltage.

The present invention provides a boosting circuit in which the above described difficulties are overcome.

Since the charging circuit for charging the boosting capacitor is provided separately from the driver, the boosting capacitor does not act as a load for the driver.

The auxiliary capacitor of the gate control circuit may be of a small capacitance value.

Reference is made, by way of example, to the accompanying drawings, in which:—

Figure 1 is a schematic circuit diagram of an example of a conventional boosting circuit;

Figure 2 is a schematic circuit diagram of a first embodiment of the present invention;

Figure 3 is a graph showing waveforms of voltages at respective parts of the circuit illustrated in Fig. 2;

Figure 4 is a schematic circuit diagram of a second embodiment of the present invention.

Figure 5 is a graph showing waveforms of voltages at respective parts of the circuit illustrated in Figure 4;

Figure 6 is a schematic circuit diagram illustrating a memory device provided with a boosting circuit embodying the present invention; and

Figure 7 is a detailed circuit diagram of a driver provided with a boosting circuit embodying the present invention.

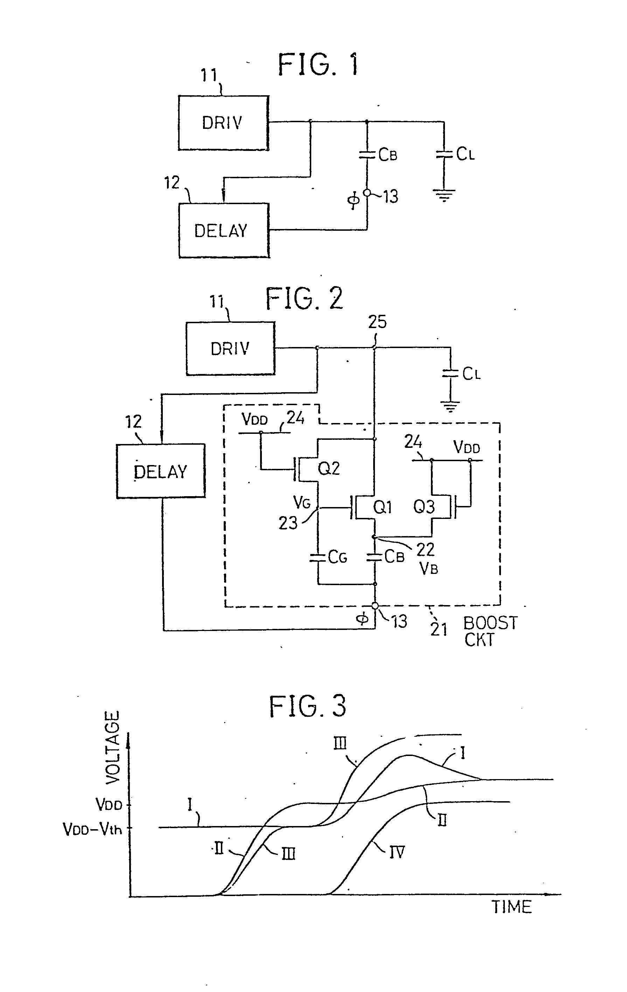

Referring to Figure 1, a description will first be given of a conventional boosting circuit. A load capacitor CL such as stray capacitance of a word line driving circuit is charged up to a voltage equal to a power source voltage ($V_{DD}$) by an output clock signal of a driver 11. A boosting capacitor CB is also charged by the output clock signal of the driver 11. The output clock signal of the driver 11 is supplied to a delay circuit 12 which produces a clock signal $\phi$. The clock signal $\phi$ (delayed by circuit 12) is supplied to the boosting capacitor CB through a terminal 13, whereby charges in the boosting capacitor CB flow into the load capacitor CL. Accordingly, the voltage V of the load capacitor CL is boosted or shifted up to a voltage higher than the voltage of the output clock signal of the driver 11. The degree of voltage boosting is determined by the voltage V1 of the clock signal $\phi$, and the ratio of the capacitances Cb and Cl of the boosting and load capacitors CB and CL as given by the equation:

$$\frac{Cb}{Cl+Cb}\text{-V1}.$$

For example, if it is assumed that the capacitances Cb and Cl of the capacitors CB and CL are equal to each other, namely Cb=Cl, the voltage V of the load capacitor is boosted by 1/2Vl and becomes 3/2Vl.

However, since the boosting capacitor CB is directly connected to the driver 11 and charged by the clock signal $\phi$ (the output clock signal) from the driver, the boosting capacitor CB acts as a load for the driver 11. Therefore, in a case in which Cb=Cl, the driver must drive a total load twice as great as the load capacitor CL. This is accompanied by disadvantages such as deformation and rounding of the voltage waveform of the clock signal, whereby the operational speed of the memory is reduced.

A boosting circuit embodying the present invention overcomes the described disadvantages of the conventional boosting circuit. In Figure 2, parts which correspond to parts in Figure 1 are designated by like reference numerals, and descriptions thereof will not be repeated.

The boosting capacitor CB is connected, through a transistor Q1, to the output side of the driver 11 and to the load capacitor CL. A connecting point 22 between the boosting capacitor CB and the transistor Q1 is connected to a line 24 of power source voltage $V_{DD}$ through a transistor Q3, and the gate and drain electrodes of the transistor Q3 are connected to the line 24. Another capacitor CG is connected between the terminal 13 and the gate electrode of the transistor Q1. Between the output side of the driver 11 and a connecting point 23, which is the connecting point between the capacitor CG and the gate of the transistor Q1, a transistor Q2 is connected to the gate electrode of which is connected to the power source line 24.

During a period when the clock signal $\phi$ is not applied to the terminal 13 and the voltage at the terminal 13 is low level (OV), the boosting capacitor CB is charged through the transistor Q3 by the power source voltage $V_{DD}$ from the line 24. A voltage VB at the point 22 is then approximately equal to the power source voltage $V_{DD}$, or precisely equal to a voltage ($V_{DD}$–Vth3), where Vth3 denotes a threshold voltage of the transistor Q3. This voltage VB is shown by a line I in Figure 3. The load capacitor CL is charged by the output clock signal voltage of the drive 11. The voltage of the load capacitor CL then becomes equal to the power source voltage $V_{DD}$, as shown by a curve II in Figure 3.

The transistor Q2, of which the gate is supplied with the power source voltage $V_{DD}$, is in ON state. Accordingly, the capacitor CG is charged through the transistor Q2 by the output clock signal of the driver 11 (from point 25). A voltage VG at the point 23 is then approximately equal to the power source voltage $V_{DD}$, or precisely equal to a voltage ($V_{DD}$–Vth2), where Vth2 denotes a threshold voltage of the transistor Q2. This voltage VG is shown by a curve III in Figure 3. For practical purposes, the voltages Vth2 and Vth3 can be taken to be equal to each other, and therefore both are denoted by Vth in Figure 3.

In a state where the capacitors CB and CG are charged up as described above, there is no current flowing through the transistors Q2 and Q3 in their ON states, since the voltage difference between source and gate electrodes of each of those transistors is not more than the threshold voltage Vth. During this time interval, the transistor Q1 is in its OFF state, and accordingly no current flows through the transistor Q1.

As described above, the boosting capacitor CB is not charged by the output clock signal of the driver 11, but is charged by the power source voltage $V_{DD}$ from the line 24 through the transistor Q3. Accordingly, the boosting capacitor CB does not burden the driver 11 as a load, whereby the load capacitor CL can be charged at a high speed.

On the other hand, the capacitor CG seems to be a load for the driver 11. However, the capacitor CG is used only for increasing the gate voltage of the transistor Q1. The capacitance value of the capacitor CG may be extremely small, for example only one hundredth of the capacitance value of the capacitor CB. The capacitance of the capacitor CG may be 0.1 PF, when the capacitance of the capacitor CB is 10 PF, for example. Therefore, the load which the capacitor CG represents for the driver 11 is almost negligible.

Next the clock signal φ from the delay circuit 12 is applied to the terminal 13. The clock signal φ has a voltage waveform as shown by a curve IV in Figure 3, of which the maximum voltage is $V_{DD}$. The voltages of the capacitors CB and CG are then shifted up towards $2V_{DD}$.

Since the voltage at the point 23 is shifted up towards $2V_{DD}$ by shifting up of the voltage of the capacitor CG, the transistor Q1 turns on (VG rises faster than VB). The transistors Q2 and Q3 turn off, when the voltages VB, VG at the points 22 and 23 exceed the voltage $V_{DD}$. Apart of the charges stored in the capacitor CB are discharged into the load capacitor CL through the transistor Q1 in the ON state, whereby the voltage of the load capacitor CL, namely the voltage at a point 25, is boosted. For example, the voltage at the point 25 is boosted up to $3/2V_{DD}$, in a case where the capacitance Cb equals the capacitance Cl. Thus, the boosting or shifting up of the voltage of the output clock signal from the driver 11 is performed.

Here, as shown in Figure 3, accompanying the incoming of the delayed clock signal φ, which acts as a boost capacitance discharge signal the voltage VG at the point 23 increases throughout as shown by curve III, while the voltage VB at the point 22 eventually decreases to the voltage (3/2 $V_{DD}$) equal to the voltage at the point 25, after increasing as shown by curve I, due to turning on of the transistor Q1 and discharging of the boosting capacitor CB in response to the boost capacitance discharge signal φ. The driver 11 is so constructed as to obstruct flow of charges from boosting capacitor CB into the driver 11, during discharging of the boosting capacitor CB.

When the level of the output clock signal from the driver 11 is low, charges in the load capacitor CL flow into the driver 11 and are discharged therethrough, whereby the voltage of the load capacitor CL, decreases. The charges in the capacitor CG also flow into the driver 11 through the transistor Q2 and are discharged therethrough, whereby the voltage VG at the point 23 decreases to turn off the transistor Q1. During an interval in which the level of the clock from the driver 11 is low, DC current does not flow from line 24 of the power source voltage $V_{DD}$ to the driver 11 through the transistors Q3 and Q1, since the transistor Q1 is in OFF state as described above.

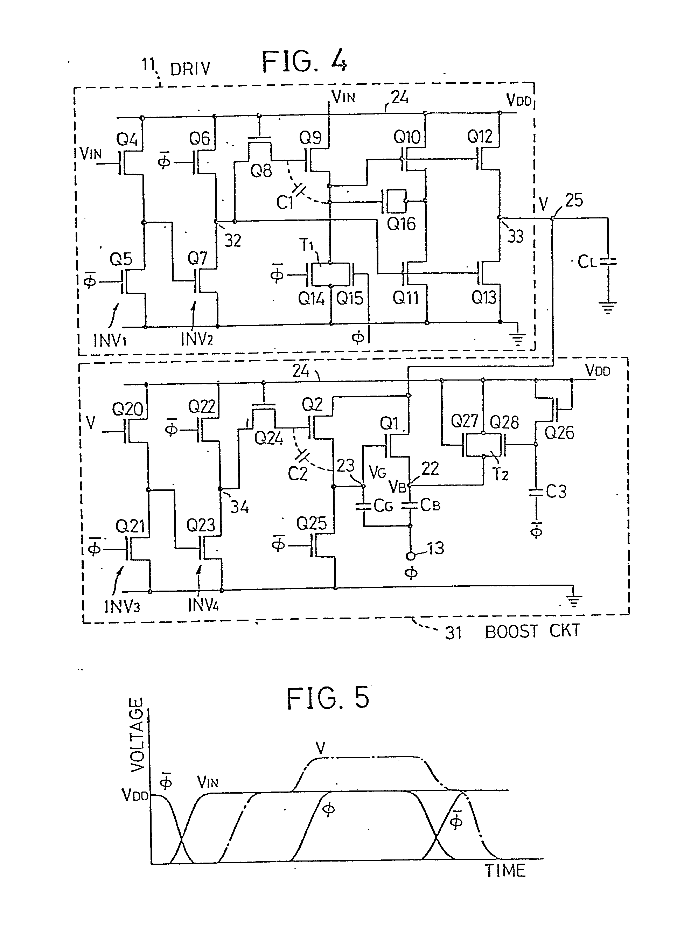

Next, a second boosting circuit embodying the present invention will be described in more detail with reference to Figure 4. In Figure 4, parts which correspond to parts in Figure 2 are designated by like reference numerals.

The driver 11 comprises transistors Q4 to Q16. Transistors Q4 and Q5 constitute a first stage inverter INV1, and transistors Q6 and Q7 constitute a second stage inverter INV2. In an initial state, the inverters INV1 and INV2 have been reset by a clock signal $\overline{\phi}$ applied to the gates of the transistors Q5 and Q6. In this state, transistors Q5 and Q6 are in ON states, and a voltage at a point 32 between transistor Q6 and Q7 is at high level. Transistors Q11 and Q13, gate electrodes of which are supplied with the voltage of the point 32, are in ON states. An output point 33, of the driver 11 is grounded through transistor Q13, whereby the output point 33 is at low level. The transistor Q8 is also in an ON state, whereby a capacitor C1 formed between the gate and source electrodes of the transistor Q9 is charged to high level through the transistor Q8.

When a clock signal $V_{IN}$ applied to the gate of transistor Q4 from an external circuit becomes high level and, at the same time, the clock signal $\overline{\phi}$ becomes low level, transistor Q4 turns on, transistors Q5 and Q6 turn off, and transistor Q7 turns on. The voltage at the point 32 becomes low level, whereby transistors Q11 and Q13 respectively assume OFF states.

As shown in Figure 5, there is a time difference between the falling-down of the clock signal $\overline{\phi}$ and the rising-up of the clock signal φ. A gate T1 consists of transistors Q14 and Q15 of which gate electrodes are respectively supplied with clock signals $\overline{\phi}$ and φ.

Immediately after the voltage of the clock signal $\overline{\phi}$ falls down, the transistors Q14 and Q15 are both in OFF states. When the voltage of the clock signal $V_{IN}$ apply to the drain electrode of the transistor Q9 becomes high level, this voltage is applied to the transistors Q10 and Q12 through the transistor Q9, whereby the transistors Q10 and Q12 turn on. The voltage V of the output clock signal of the driver 11 rises up as shown by a chain line in Figure 5 and charges the load capacitor CL.

A boosting circuit 31 comprises the transistors Q1 and Q2, transistors Q20 to Q28, and the capacitors CB and CG. Transistors Q20 and Q21 constitute a first stage inverter INV3, and transistors Q22 and Q23 constitute a second stage inverter INV4. In the initial state, clock signal $\overline{\phi}$ of high level is applied to the gates of transistors Q21 and Q22, whereby transistors Q21 and Q22 are in ON states, and a voltage at a point 34 between transistors Q22 and Q23 is at high level.

After the voltage of the clock signal $\overline{\phi}$ falls down to low level, when the voltage V of the output clock signal of the driver 11 applied to the gate electrode of the transistor Q20 rises up, the voltage at the point 34 becomes low level.

When the voltage at the point 34 and the voltage of the clock signal $\overline{\phi}$ are high, a capacitor C2 formed between the gate and source electrodes of transistor Q2 is charged to high level through transistor Q24. Transistor Q2 becomes ON. After the voltage of the clock signal $\overline{\phi}$ becomes low level, turning the transistor Q25 off, when the voltage V of the output clock signal of the driver 11 rises up, the capacitor CG is charged by the output voltage V of the driver 11 through the transistor Q2. The voltage of the gate electrode of the transistor Q2 has a higher value due to a bootstrap effect of the capacitor C2. Accordingly, the voltage VG at the point 23 becomes equal to the voltage $V_{DD}$ (V) in this embodiment, while the voltage at the point 23 is ($V_{DD}$—Vth) in the first embodiment in Figure 3.

A transmission gate T2 consists of the transistors Q27 and Q28. The transistors Q26 and Q28 correspond to the transistor Q3 of the first embodiment in Figure 2. When the clock signal $\overline{\phi}$ applied to the gate electrode of the transistor Q28 of the gate T2 through a capacitor C3 is at a high level, the boosting capacitor CB is charged by the power source voltage $V_{DD}$ from the line 24 through the gate T2. The voltage of the gate electrode of the transistor Q28 has a higher value due to a bootstrap effect of the capacitor C3. Accordingly, the voltage VB at the point 22 becomes equal to voltage $V_{DD}$ in this embodiment. In this state, the voltage VB at the point 22 equals the voltage $V_{DD}$, the voltage VG at the point 23 equals the voltage V and $V_{DD}$. The transistor Q1 is in OFF state. After completion of charging of the boosting capacitor CB, the level of the clock signal $\overline{\phi}$ decreases to low level, whereby the transistor Q28 turns off to turn the gate T2 off.

When the voltage of the clock signal applied to the terminal 13 rises up, the transistor Q1 turns on, and the charges of the boosting capacitor CB flow through the transistor Q1 to the load capacitor CL, whereby the voltage of the load capacitor CL, i.e., the voltage at the point 25 is boosted. During discharging of the boosting capacitor CB, through the transistor Q1, the gate T2 is in OFF state, whereby discharging of the boosting capacitor CB through the gate T2 to the line 24 is prevented. In the driver 11 the transistor Q13 is in OFF state as described above. Further, the transistor Q9 is OFF state since the voltage of the gate electrode of the transistor Q9 has a lower value due to the lower voltage at the point 32, and the transistor Q15 of which the gate is applied with the clock signal $\phi$ is in ON state. Consequently the transistor Q12 is in OFF state. Accordingly, no current flows into the driver 11 from the point 25 side.

Thereafter, when the voltage of the clock signal $V_{IN}$ falls down and the voltage of the clock signal $\overline{\phi}$ rises up, the voltage at the point 32 becomes high and causes the transistors Q11 and Q13 to assume ON states and the transistors Q10 and Q12 to assume OFF states. The charges of the capacitor CL are discharged through the transistor Q13 which is in ON state, whereby the voltage V at the point 25 decreases. At that time, the charges of the capacitor CG are discharged through the transistor Q2, point 25, and transistor Q13, whereby the transistor Q1 is turned off. After the transistor Q1 assumes an OFF state, the voltage of the clock $\overline{\phi}$ rises up again. Then, the transistor Q28 turns on again, and the boosting capacitor CB is charged again through the gate T2 from the line 24.

In this embodiment, the gate electrode of the transistor Q2 is not connected directly to the $V_{DD}$ line 24, but connected through the transistor Q24 to the output point 34 of the inverter INV4. Accordingly, when the voltage of the clock signal $\overline{\phi}$ becomes low, the voltage of the gate electrode of the transistor Q2 increases over the power source voltage $V_{DD}$, whereby the voltage drop across the transistor Q2 becomes substantially null. The charged voltage VG of the capacitor CG at the point 23 can be thereby increased to the voltage V, and therefore the capacitance value of the capacitor CG may be smaller since the above described charged voltage VG increases. The small capacitance value of the capacitor CG lessens the burden for the driver 11.

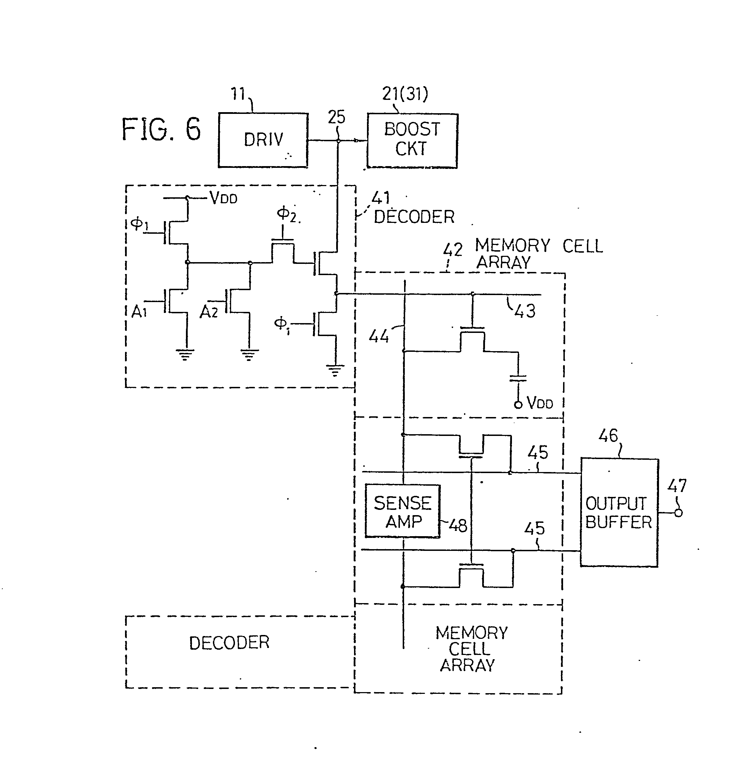

An example of a memory device which is provided with a boosting circuit 21 or 31 embodying the present invention is briefly described in conjunction with Figure 6. The voltage of the clock signal from the driver 11 is boosted by the boosting circuit (21 or 31) as described above. The boosted clock signal at the point 25 is supplied through a decoder 41 to a word line 43 in a memory cell array 42 to boost the level of the word line 43. Information at a cross point of the addressed word line 43 and a bit line 44 is amplified by a sense amplifier 48 and thereafter sent out through a data bus 45, an output buffer 46, and an output terminal 47.

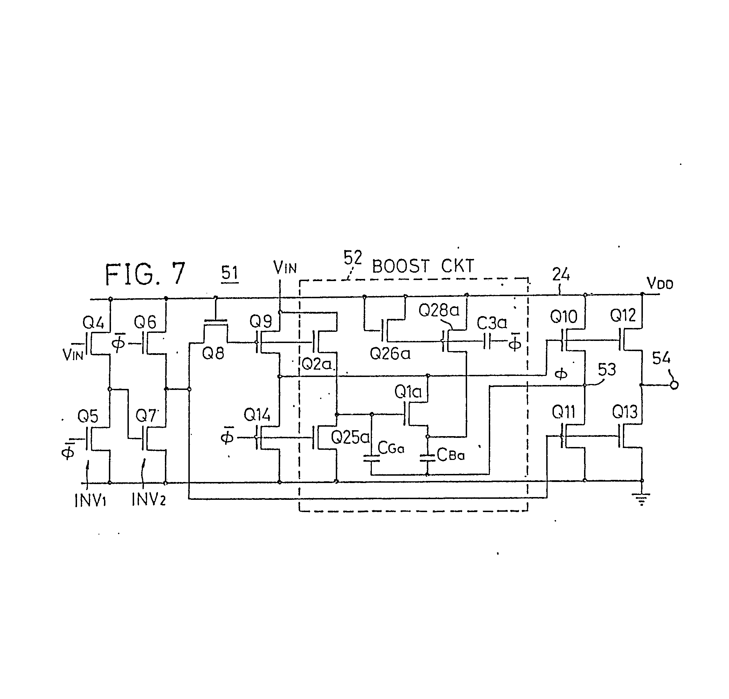

Another boosting circuit embodying the present invention as applied to a driver is next described with reference to Figure 7. In Figure 7 parts which corresponds to parts in Figure 4 are designated by like reference numerals, and descriptions thereof will not be repeated.

A driver 51 of the present embodiment is obtained by replacing the transistor Q16 for a bootstrap capacitance in the driver 11 of Figure 4 by a boosting circuit 52. The circuit construction of the boosting circuit 52 is essentially the same as that of the boosting circuit 31 in Figure 4. Transistors Q1a Q2a, Q25a, Q26a, and Q28a, and capacitors CBa, CGa, and C3a in Figure 7 correspond to transistors Q1, Q2, Q25, Q26, and Q28 and capacitors CB, CG, and C3, respectively, in Figure 4. The operation of the boosting circuit 52 is the same as that of the essentially similar parts of the boosting circuit 31, and therefore detailed description is omitted. The boosting capacitor CBa is charged through the transistor Q28a by the power source voltage $V_{DD}$ from the line 24. The capacitor CGa is charged through the transistor Q2a. When the boosting capacitor CBa is supplied with the clock signal $\phi$ from a point 53 between the transistors Q10 and Q11, the transistor Q1a turns on, and the charges of the boosting capacitor CBa flow to the transistors Q10 and Q12 which correspond to a load capacitor. Accordingly, the boosted or level shifted up clock signal is derived from an output terminal 54.

A boosting circuit boosts a voltage of a load capacitor which is charged by a specific voltage. The boosting circuit comprises a boosting capacitor one end of which is supplied with a clock signal, a charging circuit for charging the boosting capacitor, a gate circuit provided between the load capacitor and the other end of the boosting capacitor, and a gate control circuit for opening the gate circuit upon discharging of the charges of the boosting capcitor supplied with the clock signal to the load capacitor, and for closing the gate circuit during discharging of the load capacitor. The charging circuit is provided separately from a circuit for supplying the specific voltage. The charges of the boosting capacitor supplied with the clock signal flow through the gate circuit to the load capacitor.

## Claims

1. A boosting circuit, for boosting the voltage of a load capacitance (CL; Q10, Q12) when charged to a specific voltage, which boosting circuit comprises a boosting capacitance (CB; CBa), one end of which is connected to receive a boost capacitance discharge signal (φ), characterised in that a charging circuit (24, Q3; 24, Q26 to Q28, C3; Q26a, Q28a, C3a) for charging the boosting capacitance is provided separately from driver circuitry (11; 51) operable to charge the load capacitance to the said specific voltage and operable to discharge the load capacitance, a gate circuit, comprising a first transistor (Q1; Q1a), is provided between the load capacitance and the other end of the boosting capacitance, and a gate control circuit (24, Q2, Ca; 24, Q2, Ca, Q20 to Q25; 24, Q2a, CGa) is provided for opening the gate circuit for discharging the boosting capacitance, when the said one end thereof is supplied with the boost capacitance discharge signal, into the load capacitance, and for closing the gate circuit when the load capacitance is being charged by the said driver circuitry operable to charge the load capacitance to the said specific voltage and when the load capacitance is being discharged by the driver circuitry, the gate control circuit comprising an auxiliary capacitance (CG; CGa) one end of which is arranged to receive the boost capacitance discharge signal and the other end of which is connected to the gate circuit, and a second transistor (Q2; Q2a) connected between the other end of the auxiliary capacitance and driver circuitry operable to charge the load capacitance to the said specific voltage.

2. A boosting circuit as claimed in claim 1, wherein the said other end of the auxiliary capacitance (CG; CGa) is connected to the gate electrode of the first transistor.

3. A boosting circuit as claimed in claim 1 or 2, in which the said charging circuit comprises a power source voltage line (24) and supply circuitry (Q3; Q26 to Q28; Q26a, Q28a) connected between the power source voltage line and the said other end of the boosting capacitance (CB; CBa) operable to supply power source voltage ($V_{DD}$) to the boosting capacitance.

4. A boosting circuit as claimed in claim 3, in which the gate electrode of the second transmission (Q2; Q2a) is connected to the power source voltage line (24).

5. A boosting circuit as claimed in claim 3 or 4, in which the said supply circuitry of the said charging circuit comprises a third transistor (Q3; Q26, Q28; Q26a, Q28a) which is connected between the power source voltage line (24) and the said other end of the boosting capacitance (CB; CBa), and the gate electrode of the said third transistor is connected to the power source voltage line.

6. A boosting circuit as claimed in claim 1, 2, 3, 4 or 5, in which the capacitance value of the auxiliary capacitance (CG; CGa) is smaller than the capacitance value of the boosting capacitance (CB; CBa).

7. A boosting circuit as claimed in any preceding claim, in which the charging circuit comprises one transistor (Q26; Q26a) connected to a power source voltage line (24), and another transistor (Q28; Q28a) connected to the power source voltage line (24), and the boosting capacitance (CB; CBa), and an auxiliary charging capacitance (C3; C3a) one end of which is connected to a connecting point between the said one and other transistors, the other end of which is supplied with an auxiliary signal (φ̄) different in timing from the boost capacitance discharge signal (φ).

8. A boosting circuit as claimed in any preceding claim, wherein the said boost capacitance discharge signal is a clock signal which is delayed in timing from a signal employed for causing charging of the load capacitance to a specific voltage.

9. A boosting circuit as claimed in claim 1 or 2, wherein the said specific voltage is provided externally of the driver circuitry operable to charge the load capacitance to the said specific voltage.

## Patentansprüche

1. Spannungserhöhungsschaltung zur Erhöhung der Spannung einer Lastkapazität (CL; Q10, Q12), wenn diese auf eine spezifische Spannung aufgeladen ist, mit einer Spannungserhöhungskapazität (CB; CBa), von der ein Ende zum Empfang eines Entladesignals (φ) der Spannungserhöhungskapazität angeschlossen ist, dadurch gekennzeichnet, daß eine Ladeschaltung (24, Q3; 24, Q26 bis Q28, C3; Q26a, Q28a, C3a) zum Laden der Spannungserhöhungskapazität separat von einer Treiberschaltung (11; 51) vorgesehen ist, die betreibbar ist, um die Lastkapazität auf die genannte spezifische Spannung aufzuladen, und die betreibbar ist, um die Lastkapazität zu entladen, und daß eine Torschaltung, die einen ersten Transistor (Q1; Q1a) umfaßt, zwischen der Lastkapazität umd dem anderen Ende der Spannungserhöhungskapazität vorgesehen ist, und daß eine Torsteuerschaltung (24, Q2, Ca; 24, Q2, Ca, Q20 bis Q25; 24, Q2a, CGa) vorgesehen ist, zur Öffnung der Torschaltung zur Entladung der Spannungserhöhungskapazität in die Lastkapazität, wenn deren genanntem einen Ende das Entladesignal der Spannungserhöhungskapazität zugeführt wird, und zum Schließen der Torschaltung, wenn die Lastkapazität durch die genannte Treiberschaltung aufgeladen wird, und die betätigbar ist, um die Lastkapazität auf die genannte spezifische Spannung aufzuladen, und wenn die Lastkapazität durch die Treiberschaltung entladen wird, wobei die Torsteuerschaltung eine Hilfskapazität (CG; CGa) umfaßt, von der ein Ende so angeordnet ist, daß es das Entladesignal der Spannungserhöhungskapazität empfängt, und deren anderes Ende mit der Torschaltung verbunden ist, und daß eine zweiter Transistor (Q2; Q2a), der zwischen das andere Ende der Hilfskapazität und die Treiberschaltung angeschlossen ist, betätigt werden kann, um die Lastkapazität auf die genannte spezifische Spannung aufzuladen.

2. Spannungserhöhungsschaltung nach Anspruch 1, bei welcher das genannte andere Ende der Hilfskapazität (CG; CGa) mit der Gateelektrode des ersten Transistors verbunden ist.

3. Spannungserhöhungsschaltung nach Anspruch 1 oder 2, bei welcher die genannte Ladeschaltung eine Energiequellenspannungleitung (24) und eine Versorgungsschaltung (Q3; Q26 bis Q28; Q26a, Q28a) umfaßt, die zwischen die Energiequellenspannungleitung und das genannte andere Ende der Spannungserhöhungskapazität (CB; CBa) angeschlossen und betreibbar ist, um der Spannungserhöhungskapazität Energieversorgungsquellenspannung ($V_{DD}$) zuzuführen.

4. Spannungserhöhungsschaltung nach Anspruch 3, bei welcher die Gateelektrode des zweiten Transistors (Q2; Q2a) mit der Energiequellenspannungsleitung (24) verbunden ist.

5. Spannungserhohüngsschaltung nach Anspruch 3 oder 4, bei welcher die genannte Versorgungsschaltung der genannten Ladeschaltung einen dritten Transistor (Q3; Q26, Q28; Q26a, Q28a) umfaßt, der zwischen der Energiequellenspannungleitung (24) und dem genannten anderen End der Spannungserhöhungskapazität (CB; CBa) angeschlossen ist, und daß die Gateelektrode des genannten dritten Transistors mit der Energiequellenspannungleitung verbunden ist.

6. Spannungserhöhungsschaltung nach Anspruch 1, 2, 3, 4 oder 5, bei welcher der Kapazitätswert der Hilfskapazität (CG; CGa) kleiner als der Kapazitätswert der Spannungserhöhungskapazität (CH; CBa) ist.

7. Spannungserhöhungsschaltung nach einem der vorhergehenden Ansprüche, bei welcher die Ladeschaltung wenigstens einen Transistor (Q26; A26a) umfaßt, der mit einer Energiequellenspannungsleitung (24) verbunden ist, und einen weiteren Transistor (Q28; Q28a), der mit der Energiequellenspannungsleitung (24) und der Spannungserhöhungskapazität (CB; CBa) verbunden ist, und mit einer Hilfsladungskapazität (C3; C3a), von der ein Ende mit einem Verbindungspunkt zwischen dem genannten einen und dem anderen Transistor verbunden ist, und deren anderes Ende ein Hilfssignal ($\overline{\phi}$) zugeführt wird, welches eine andere Zeitlage als das Entladesignal der Spannungshöhungskapazität ($\phi$) hat.

8. Spannungshöhungsschaltung nach einem der vorhergehenden Ansprüche, bei welcher das genannte Entladesignal der Spannungserhöhungskapazität ein Taktsignal ist, welches zeitlich gegenüber einem Signal verzögert ist, das zur Verursachung der Aufladung der Lastkapazität auf eine spezifische Spannung verwendet wird.

9. Spannungserhöhungsschaltung nach Anspruch 1 oder 2, bei welcher die genannte spezifische Spannung außerhalb der Treiberschaltung vorgesehen ist, welche betreibbar ist, um die Lastkapazität auf die genannte spezifische Spannung aufzuladen.

**Revendications**

1. Circuit survolteur pour surélever la tension d'un condensateur de charge (CL; Q10, Q12) quand il est chargé à une tension spécifique, ce circuit sorvolteur comprenant un condensateur de survoltage (CB; CBa) dont une extrémité est connectée pour recevoir un signal de décharge de condensateur de survoltage ($\phi$), caractérisé en ce qu'il comprend un circuit de charge (24, Q3; 24, Q26 à Q28, C3; Q26a, Q28a, C3a) destiné à charger le condensateur de survoltage et prévu séparément d'un circuit d'excitation (11; 51) agencé pour charger la condensateur de charge à ladite tension spécifique et agencé pour décharger le condensateur de charge, un circuit à porte, comprenant un premier transistor (Q1; Q1a) et prévu entre le condensateur de charge et l'autre extrémité du condensateur de survoltage, et un circuit de commande de circuit à porte (24, Q2, Ca; 24, Q2, Ca, Q20 à Q25; 24, Q2a, CGa) prévu pour ouvrir le circuit à porte afin de décharger le condensateur de survoltage, quand sadite extrémité reçoit le signal de décharge de condensateur de survoltage, dans le condensateur de charge, et pour fermer le circuit à porte quand le condensateur de charge est chargé par le circuit d'excitation agencé pour charger le condensateur de charge à la tension spécifique et quand le condensateur de charge est déchargé par le circuit d'excitation, le circuit de commande de circuit à porte comprenant un condensateur auxiliaire (CG; CGa) dont une extrémité est disposée pour recevoir le signal de décharge de condensateur de survoltage et dont l'autre extrémité est connectée au circuit à porte, et un second transistor (Q2; Q2a) connecté entre l'autre extrémité du condensateur auxiliaire et le circuit d'excitation agencé pour charger le condensateur de charge à la tension spécifique.

2. Circuit survolteur selon la revendication 1, caractérisé en ce que l'autre extrémité du condensateur auxiliaire (CG; CGa) est connectée à l'électrode de grille du premier transistor.

3. Circuit survolteur selon l'une quelconque des revendications 1 et 2, caractérisé en ce que le circuit de charge comprend une ligne de tension d'alimentation (24) et un circuit d'alimentation (Q3; Q26 à Q28; Q26a, Q28a) connecté entre la ligne de tension d'alimentation et l'autre extrémité du condensateur de survoltage (CB; CBa) et agencé pour fournir une tension d'alimentation ($V_{DD}$) au condensateur de survoltage.

4. Circuit survolteur selon la revendication 3, caractérisé en ce que l'électrode de grille du second transistor (Q2; Q2a) est connectée à la ligne de tension d'alimentation (24).

5. Circuit survolteur selon l'une quelconque des revendications 3 et 4, caractérisé en ce que ledit circuit d'alimentation du circuit de charge comprend un troisième transistor (Q3; Q26, Q28; Q26a, Q28a) qui est connecté entre la ligne de tension d'alimentation (24) et l'autre extrémité du condensateur de survoltage (CB; CBa), et en ce que l'électrode de grille du troisième transistor est connectée à la ligne de tension d'alimentation.

6. Circuit survolteur selon l'une quelconque des revendications 1 à 5, caractérisé en ce que la valeur de capacité du condensateur auxiliaire (CG; CGa) est inférieure à la valeur de capacité du condensateur de survoltage (CB; CBa).

7. Circuit survolteur selon l'une quelconque des revendications 1 à 6, caractérisé en ce que le circuit de charge comprend un transistor (Q26; Q26a) connecté à une ligne de tension d'alimentation (24), et une autre transistor (Q28; Q28a) connecté à la ligne de tension d'alimentation (24), et au condensateur de survoltage (CB; CBa), et un condensateur de charge auxiliaire (C3; C3a) dont une extrémité est connectée à un point de connexion situé entre l'un et l'autre transistor et dont l'autre extrémité reçoit un signal auxiliaire ($\overline{\phi}$) différent dans le temps du signal de décharge de condensateur de survoltage ($\phi$).

8. Circuit survolteur selon l'une quelconque des revendications 1 à 7, caractérisé en ce que le signal de décharge de condensateur de survoltage est un signal d'horloge qui est retardé dans le temps par rapport à un signal utilisé pour provoquer la charge du condensateur de charge à une tension spécifique.

9. Circuit survolteur selon l'une quelconque des revendications 1 et 2, caractérisé en ce que la tension spécifique est fournie de l'extérieur du circuit d'excitation agencé pour charge le condensateur de charge à la tension spécifique.

FIG. 1

FIG. 2

FIG. 3

# FIG. 4

11 DRIV

24

INV1    INV2      31 BOOST CKT

# FIG. 5

FIG. 6

FIG. 7 <u>51</u> $V_{IN}$ 52 BOOST CKT 24 $V_{DD}$

Q4 Q6 Q9 Q28a C3a Q10 Q12

$V_{\overline{IN}}$ $\overline{\phi}$ Q8 Q2a Q26a $\overline{\phi}$ 54

Q1a 53 $\phi$

Q5 Q7 Q14 Q25a Q11 Q13

$\overline{\phi}$ $\overline{\phi}$ $C_{Ga}$ $C_{Ba}$

$INV_1$ $INV_2$